# EUROPÄISCHE PATENTSCHRIFT

(11) **EP 1 198 836 B1**
(45) Veröffentlichungstag und Bekanntmachung des Hinweises auf die Patenterteilung: **30.11.2005**
(21) Anmeldenummer: 00945612.0
(22) Anmeldetag: 06.06.2000
(51) Int. Cl.: H01L 23/525

(54) **FUSE FÜR HALBLEITERANORDNUNG**
FUSE FOR SEMICONDUCTOR DEVICE
FUSIBLE POUR DISPOSITIF A SEMICONDUCTEUR

(30) Priorität: 08.06.1999 DE 19926107
(43) Veröffentlichungstag der Anmeldung: 24.04.2002
(73) Patentinhaber: Infineon Technologies AG, 81669 München (DE)
(72) Erfinder: LE, Thoai-Thai, D-81737 München (DE); LINDOLF, Jürgen, D-86316 Friedberg (DE)
(74) Vertreter: Müller - Hoffmann & Partner
(86) Internationale Anmeldenummer: PCT/DE2000/001867
(87) Internationale Veröffentlichungsnummer: WO 2000/075987

(56) Entgegenhaltungen:
- EP-A- 0 903 784
- US-A- 3 863 231
- PATENT ABSTRACTS OF JAPAN vol. 007, no. 115 (E-176), 19. Mai 1983 (1983-05-19) & JP 58 033865 A (TOKYO SHIBAURA DENKI KK), 28. Februar 1983 (1983-02-28)

## Beschreibung

Die vorliegende Erfindung betrifft eine Fuse für eine Halbleiteranordnung mit einem Halbleiterkörper mit zwei im wesentlichen parallel zueinander verlaufenden Hauptoberflächen.

Fuses werden bekanntlich in Halbleiteranordnungen und insbesondere in Halbleiterspeichern mit zunehmender Bedeutung eingesetzt: sie dienen dazu, bei Ausfall einzelner Elemente, wie beispielsweise Speicherzellen oder Wortleitungen, entsprechende Ersatz- bzw. Redundanzelemente zuzuschalten. Wird beispielsweise bei einem Test eines Halbleiterspeichers eine Wortleitungen als fehlerhaft festgestellt, so wird durch Trennen oder Zünden von Fuses anstelle der fehlerhaften Wortleitung eine redundante Wortleitung aktiviert. Auch können beispielsweise Chipoptionen über Fuses geschaltet werden.

Es gibt nun zwei verschiedene Arten, Fuses zu trennen: bei einer ersten Art erfolgt die Trennung durch Einwirkung eines Laserstrahles, so daß eine sogenannte Laserfuse vorliegt. Bei der zweiten Art wird die Trennung durch elektrische Zerstörung infolge Wärmeentwicklung vorgenommen; hier wird von einer elektrischen bzw. E-Fuse gesprochen.

Beiden Fusearten ist gemeinsam, daß sie nur planar hergestellt werden (vgl. beispielsweise US 5 663 590 und US 5 731 624). Das heißt, Kontakte einer Fuse liegen in einer Ebene, die im wesentlichen parallel zu einer Hauptoberfläche des Halbleiterkörpers einer Halbleiteranordnung, also beispielsweise eines Halbleiterspeichers, verläuft. Eine derartige Struktur ist schematisch in Fig. 6 dargestellt, die erste Kontakte 1 und zweite Kontakte 2 zeigt, welche jeweils auf leitenden Bereichen 3, die beispielsweise aus hochdotiertem Silizium bestehen, angeordnet sind. Diese Bereiche 3 sind über eine Fuse 4 elektrisch miteinander verbunden, die zwischen den Bereichen 3 eine leitende Verbindung darstellt. Diese Fuse 4 kann beispielsweise aus dotiertem polykristallinem Silizium oder auch aus Metall bestehen. Die Fuse 4 selbst ist fein gestaltet und hat eine Breite in der Größenordnung von einigem µm bis weniger als 1 µm.

Fließt nun ein Strom zwischen den Kontakten 1 und 2, der einen gewissen Grenzwert überschreitet, so wird die Fuse 4 durch die durch den Stromfluß erzeugte Joulsche Wärme zerstört. Das heißt, die Fuse wird durchtrennt. Die Programmierspannung ist dabei größer als die Betriebsspannung des Chips. Die Höhe der Programmierspannung ist unter anderem abhängig von der Breite der Fuses.

Selbstverständlich kann dieses Durchtrennen einer Fuse 4 auch durch Einwirkung eines Laserstrahles vorgenommen werden, was insbesondere dann zweckmäßig ist, wenn die Fuse 4 sich auf der Oberfläche einer Halbleiteranordnung befindet.

Wie nun sofort aus der Fig. 6 zu ersehen ist, benötigt eine Fuse zusammen mit den zugeordneten Kontakten 1, 2 eine nicht zu vernachlässigende Fläche auf einem Halbleiterchip. Bei der ständig angestrebten Miniaturisierung von Halbleiteranordnungen ist dieser Flächenbedarf für Fuses störend. Dies gilt insbesondere für Halbleiterspeicher, da in solchen eine Vielzahl von Fuses benötigt wird.

Es ist daher Aufgabe der vorliegenden Erfindung, eine Fuse für eine Halbleiteranordnung anzugeben, die sich durch einen minimalen Flächenbedarf auszeichnet; außerdem soll ein Verfahren zum Herstellen einer solchen Fuse geschaffen werden; um die Programmierspannung niedrig halten zu können, soll sich der Durchmesser der Fuse auf Werte einstellen lassen können, die sehr viel kleiner als 1 µm sind.

Diese Aufgabe wird bei einer Fuse für eine Halbleiteranordnung mit einem Halbleiterkörper mit zwei im wesentlichen parallel zueinander verlaufenden Hauptoberflächen erfindungsgemäß dadurch gelöst, daß die Fuse sich in der Richtung zwischen den beiden Hauptoberflächen erstreckt und in einen Hohlraum des Halbleiterkörpers eingebettet ist.

Die erfindungsgemäße Fuse ist also nicht wie sämtliche bestehenden Fuses in einer planaren Struktur entsprechend der Fig. 6 angeordnet. Sie ist vielmehr in "vertikaler" Richtung zwischen den beiden Hauptoberflächen der Halbleiteranordnung vorgesehen. Allein dadurch wird eine erhebliche Flächeneinsparung erzielt, so daß eine wesentlich verbesserte Packungsdichte für Halbleiteranordnungen mit Fuses zu erreichen ist. Auch läßt sich der Durchmesser der Fuses ohne weiteres auf Werte erheblich unterhalb 1 µm einstellen, was niedrige Programmierspannungen zur Folge hat.

Das Einschließen der Fuses in einen Hohlraum ist aus der Patentschrift EP 0 903 784 A bekannt und hat einen weiteren vorteilhaften Effekt, der mit den bisherigen planaren Fuses nur unter hohem Aufwand und Platzbedarf zu erzielen ist: beim Zerstören der Fuses durch deren Schmelzen können keine unerwünschten Kurzschlüsse durch abgedampftes Material entstehen, da diese Dämpfe zuverlässig in dem Hohlraum eingeschlossen werden. Es sind also keine besonderen Maßnahmen erforderlich, um Kurzschlüsse zu vermeiden, die beim Zerstören von planaren Fuses auftreten können. Solche Maßnahmen liegen bei den bestehenden Fuses darin, bestimmte Mindestabstände zu benachbarten Elementen oder anderen Fuses einzuhalten oder Schutzringstrukturen um die Fuses vorzusehen.

Ein Verfahren zum Herstellen der erfindungsgemäßen Fuse zeichnet sich speziell durch die folgenden Verfahrensschritte aus:
- Auf ein Halbleitersubstrat aus beispielsweise Silizium wird eine selektiv zu diesem ätzbare Isolatorschicht aus beispielsweise Siliziumnitrid aufgebracht,
- diese Isolatorschicht und das Halbleitersubstrat werden sodann anisotrop strukturiert, so daß unter der nach der Strukturierung verbleibenden Isolatorschicht eine säulenartige Halbleiterschicht entsteht,
- die säulenartige Halbleiterschicht wird sodann isotrop überätzt, wobei in diesem Schritt Breite und elektrische Eigenschaften der Fuse problemlos einzustellen sind, und
- auf die verbleibende Struktur wird ein Dielektrikum aus beispielsweise Siliziumdioxid anisotrop aufgetragen, was durch Aufdampfen geschehen kann, wodurch ein Hohlraum gebildet wird.

Anschließend erfolgen noch in üblicher Weise eine Kontaktierung der so hergestellten Fuse, sowie deren Metallisierung mit anschließender Passivierung. Bei der Kontaktierung kann gegebenenfalls ein Buried-Layer-Kontakt eingesetzt werden, was zu einer weiteren Verbesserung der Packungsdichte beiträgt.

Die Fuse selbst besteht in vorteilhafter Weise aus dotiertem oder undotiertem Silizium. Sie kann dabei eine Länge bis zu einigen µm und einen Durchmesser von etwa 0,1 bis 0,5 µm aufweisen.

An ihrem dem Halbleiterkörper zugewandten Ende ist die Fuse beispielsweise mit einem Buried-Layer kontaktiert, wie dies bereits oben erwähnt wurde, während an ihrem gegenüberliegenden Ende, das sich in der Nähe einer Hauptoberfläche des Halbleiterkörpers befindet, ein metallischer Kontakt aus beispielsweise Wolfram mit entsprechender Kontaktdiffusion vorgesehen werden kann. Ein solcher Wolframkontakt kann dann an eine Leiterbahn aus beispielsweise Aluminium, Wolfram oder polykristallinem Silizium angeschlossen werden.

Nachfolgend wird die Erfindung anhand der Zeichnung näher erläutert. Es zeigen:
- Fig. 1: eine Schnittdarstellung durch die erfindungsgemäße Fuse,
- Fig. 2 bis 4: schematische Schnittdarstellungen zur Erläuterung eines Verfahrens zum Herstellen der erfindungsgemäßen Fuse,
- Fig. 5: ein Schaltbild einer Fuse mit einem MOS-Transistor und
- Fig. 6: eine Draufsicht auf eine bestehende planare Fuse.

Die Fig. 6 ist bereits eingangs erläutert worden. In den Figuren werden für einander entsprechende Bauteile jeweils die gleichen Bezugszeichen verwendet.

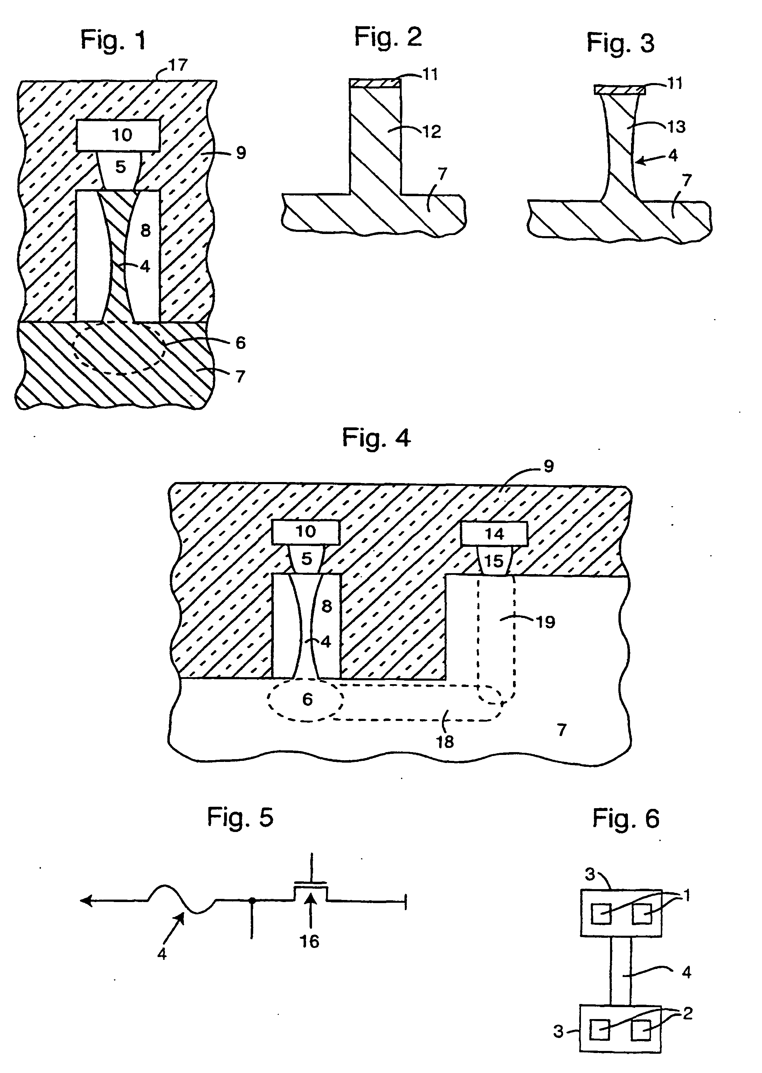

Fig. 1 zeigt eine Fuse 4 aus Silizium, die eine Länge von etwa 1 bis 2 µm und an ihrer schmalsten Stelle einen Durchmesser von etwa 0,1 bis 0,2 µm aufweist und sich zwischen einem Kontakt 5 aus beispielsweise Wolfram und einem Buried-Layer 6 in einem Halbleiterkörper 7 erstreckt. Die Fuse 4 ist dabei in einem Hohlraum 8 angeordnet, der von einer Isolatorschicht 9 aus beispielsweise Siliziumdioxid umgeben ist, in der eine Leiterbahn 10 aus Aluminium, Wolfram oder polykristallinem Silizium zu dem Wolframkontakt 5 verläuft.

Selbstverständlich können anstelle der angegebenen Materialien auch andere geeignete Materialien oder Kombinationen von diesen eingesetzt werden. So kann beispielsweise die Isolatorschicht 9 auch aus Siliziumnitrid oder aus einzelnen Filmen aus Siliziumdioxid und Siliziumnitrid bestehen.

Bei der Herstellung der in Fig. 1 gezeigten Fuse wird von einem beispielsweise aus Silizium bestehenden Halbleitersubstrat ausgegangen, auf das eine selektiv zu diesem Substrat ätzbare Schicht aus beispielsweise Siliziumnitrid aufgetragen wird. Diese Siliziumnitridschicht wird so strukturiert, daß lediglich an den Teilen des Siliziumsubstrates eine Siliziumnitridschicht 11 zurückbleibt, an denen später eine Fuse erzeugt werden soll. Es schließt sich sodann ein Ätzschritt an, bei dem das Siliziumsubstrat, das nicht von der Siliziumnitridschicht 11 bedeckt ist, bis zu einer bestimmten Tiefe abgetragen wird. Es entsteht damit die in Fig. 2 gezeigte Struktur, bei der die beispielsweise in Draufsicht runde Siliziumnitridschicht 11 das hier säulenförmig gestaltete Halbleitersubstrat bedeckt, das mit der Bezeichnung der Fig. 1 aus dem eigentlichen Halbleiterkörper 7 und einem säulenförmigen Halbleiterbereich 12 besteht. Dieser säulenförmige Halbleiterbereich 12 bildet die Grundstruktur für die spätere Fuse.

Die Gestaltung der Halbleiteranordnung von Fig. 2 erfolgt vorzugsweise durch anisotrope Strukturierung der Siliziumnitridschicht 11 und des Halbleitersubstrates. Die Siliziumnitridschicht kann hierbei zur Markierung verwendet werden.

Es schließt sich sodann ein isotropes Überätzen an, bei dem der Halbleiterbereich 12 selektiv "dünner" gestaltet wird. Das heißt, in diesem Schritt wird die Querschnittsfläche eines verbleibenden Halbleiterbereiches 13 eingestellt. Mit anderen Worten, das isotrope Überätzen ermöglicht ein einfaches Festlegen der gewünschten elektrischen Eigenschaften der schließlich auf diese Weise entstehenden Fuse 4.

Es schließt sich sodann ein anisotropes Auffüllen mit einem Dielektrikum aus beispielsweise einer Siliziumdioxidschicht 9 an. Durch dieses anisotrope Auffüllen des Dielektrikums wird um die Fuse 4 herum ein Hohlraum 8 erzeugt.

Es folgen dann in üblicher Weise eine Planarisierung durch chemisch-mechanisches Polieren und eine Präparation des Wolframkontaktes 5 und der Leiterbahn 10, die ebenfalls in die Isolatorschicht 9 aus Siliziumdioxid eingebettet sind. Dabei kann der Halbleiterkörper 7 mit einem weiteren Kontakt 15 und einer weiteren Leiterbahn 14 versehen werden, die aus entsprechenden Materialien wie der Kontakt 5 bzw. die Leiterbahn 10 bestehen. Der Kontakt 15 mit der Leiterbahn 14 kann dabei niederohmig über eine Diffusionszone 19 mit einem Vorsprung 18 des Buried-Layers 6 verbunden werden, so daß die Fuse 4 beidseitig kontaktiert ist.

Auf eine solche beidseitige Kontaktierung kann gegebenenfalls verzichtet werden, wenn die Fuse 4, wie schematisch in Fig. 5 gezeigt ist, direkt an eine Elektrode beispielsweise eines Transistors 16 angeschlossen ist.

Die Erfindung ermöglicht durch die vertikale Strukturierung der Fuse eine erhebliche Platzeinsparung bei Halbleiteranordnungen. Dies ist insbesondere bei Halbleiterspeichern von Bedeutung, da hier hohe Packungsdichten besonders angestrebt werden. Dabei weicht die Erfindung vollkommen von den bisherigen Strukturen ab, die alle planare Gestaltungen von Fuses vorsehen. Durch die Erfindung wird eine Möglichkeit geschaffen, mit geringem Aufwand Fuses in vertikaler Anordnung herzustellen.

Die erfindungsgemäße Fuse wird in bevorzugter Weise "elekrisch" gezündet. Gegebenenfalls ist aber auch eine Zündung durch Einwirkung eines Laserstrahles möglich. Dies gilt insbesondere dann, wenn die Fuse 4 etwas "schräg" zu einer Hauptoberfläche 17 der Halbleiteranordnung vorgesehen wird. Diese Hauptoberfläche 17 verläuft im wesentlichen parallel zu einer gegenüberliegenden, nicht gezeigten Hauptoberfläche des Halbleiterkörpers 7.

## Patentansprüche

1. Fuse für Halbleiteranordnung mit einem Halbleiterkörper (7) und einer auf einer Hauptoberfläche des Halbleiterkörpers (7) vorgesehenen Isolatorschicht (9), wobei die Fuse einen schmelzbaren Teil (4) aufweist,
**dadurch gekennzeichnet, dass**
der schmelzbare Teil (4) sich in der Richtung von der Hauptoberfläche des Halbleiterkörpers (7) zur Oberfläche (17) der Isolatorschicht (9) senkrecht zur Hauptoberfläche erstreckt und in einen Hohlraum (8) eingebettet ist, der auf der Hauptoberfläche des Halbleiterkörpers (7) in der Isolatorschicht (9) vorgesehen ist.

2. Fuse nach Anspruch 1,
**dadurch gekennzeichnet, dass**
der schmelzbare Teil (4) aus dotiertem oder undotiertem Silizium besteht.

3. Fuse nach Anspruch 2,
**dadurch gekennzeichnet, dass**
die Länge des schmelzbaren Teiles (4) bis einige µm und ihr Durchmesser etwa 0,1 bis 0,5 µm betragen.

4. Fuse nach einem der Ansprüche 1 bis 3,
**dadurch gekennzeichnet, dass**
der schmelzbare Teil (4) an seinem dem Halbleiterkörper (7) zugewandten Ende mit einem Buried-Layer (6) und an seinem gegenüberliegenden Ende mit einem metallischen Kontakt (5) versehen ist.

5. Fuse nach Anspruch 4,
**dadurch gekennzeichnet, dass**
der metallische Kontakt aus Wolfram besteht.

6. Fuse nach Anspruch 4 oder 5,
**dadurch gekennzeichnet, dass**
der metallische Kontakt mit einer Leiterbahn (10) versehen ist.

7. Fuse nach einem der Ansprüche 1 bis 6,
**dadurch gekennzeichnet, dass**
die Isolatorschicht aus Siliziumdioxid besteht.

8. Verfahren zum Herstellen der Fuse nach einem der Ansprüche 1 bis 7,
**dadurch gekennzeichnet, dass**
- auf ein Halbleitersubstrat eine selektiv zu diesem ätzbare Isolatorschicht (11) aufgebracht wird,
- die Isolatorschicht (11) und das Halbleitersubstrat anisotrop strukturiert werden, sodass unter der verbleibenden Isolatorschicht (11) ein säulenförmiger Halbleiterbereich (12) zurückbleibt,
- der Halbleiterbereich (12) isotrop überätzt wird, sodass ein verdünnter Halbleiterbereich (13) zurückbleibt, und
- ein Dielektrikum (9) anisotrop auf die verbleibende Isolatorschicht (11) und das Halbleitersubstrat so aufgetragen wird, dass der verdünnte Halbleiterbereich (13) von einem Hohlraum (8) seitlich umgeben bleibt.

## Claims

1. Fuse for a semiconductor arrangement having a semiconductor body (7) and having an insulator layer (9) provided on one main surface of the semiconductor body (7), with the fuse having a fusible part (4),
**characterized in that**
the fusible part (4) extends in the direction of the main surface of the semiconductor body (7) toward the surface (17) of the insulator layer (9) at right angles to the main surface, and is embedded in a cavity (8) which is provided in the insulator layer (9) on the main surface of the semiconductor body (7).

2. Fuse according to Claim 1,
**characterized in that**
the fusible part (4) is composed of doped or undoped silicon.

3. Fuse according to Claim 2,
**characterized in that**
the length of the fusible part (4) is up to a few µm, and its diameter is approximately 0.1 to 0.5 µm.

4. Fuse according to one of Claims 1 to 3,
**characterized in that**
the fusible part (4) is provided with a buried layer (6) at its end facing the semiconductor body (7), and is provided with a metallic contact (5) at its opposite end.

5. Fuse according to Claim 4,
**characterized in that**
the metallic contact is composed of tungsten.

6. Fuse according to Claim 4 or 5,
**characterized in that**
the metallic contact is provided with an interconnect (10).

7. Fuse according to one of Claims 1 to 6,
**characterized in that**
the insulator layer is composed of silicon dioxide.

8. Method for producing the fuse according to one of Claims 1 to 7,
**characterized in that**
- an insulator layer (11), which can be etched selectively with respect to a semiconductor substrate, is applied to said semiconductor substrate,
- the insulator layer (11) and the semiconductor substrate are anisotropically structured, so that a semiconductor area (12) in the form of a column remains under the remaining insulator layer (11),
- the semiconductor area (12) is isotropically etched over, so that a thinned semiconductor area (13) remains, and
- a dielectric (9) is applied anisotropically to the remaining insulator layer (11) and to the semiconductor substrate such that the thinned semiconductor area (13) remains, surrounded by a cavity (8) at the side.

## Revendications

1. Fusible pour dispositif à semi-conducteur, comprenant un corps (7) semi-conducteur et une couche (9) isolante prévue sur une surface principale du corps (7) semi-conducteur, le fusible ayant une partie (4) qui peut fondre,
**caractérisé en ce que**
la partie (4) qui peut fondre s'étend dans la direction allant de la surface principale du corps (7) à semi-conducteur à la surface (17) de la couche (9) isolante perpendiculairement à la surface principale et est incorporée dans une cavité (8) qui est prévue sur la surface principale du corps (7) semi-conducteur dans la couche (9) isolante.

2. Fusible suivant la revendication 1,
**caractérisé en ce que**
la partie (4) qui peut fondre est en silicium dopé ou non dopé.

3. Fusible suivant la revendication 2,
**caractérisé en ce que**
la longueur de la partie (4) qui peut fondre va jusqu'à quelques µm et son diamètre est compris entre environ 0,1 et 0,5 µm.

4. Fusible suivant l'une des revendications 1 à 3,
**caractérisé en ce que**
la partie (4) qui peut fondre est munie à son extrémité tournée vers le corps (7) semi-conducteur d'une couche (6) enterrée et à son extrémité opposée d'un contact (5) métallique.

5. Fusible suivant la revendication 4,
**caractérisé en ce que**
le contact métallique est en tungstène.

6. Fusible suivant la revendication 4 ou 5,
**caractérisé en ce que**
le contact métallique est muni d'une piste (10) conductrice.

7. Fusible suivant l'une des revendications 1 à 6,
**caractérisé en ce que**
la couche isolante est en dioxyde de silicium.

8. Procédé de production du fusible suivant l'une des revendications 1 à 7,
**caractérisé en ce que**
- on dépose sur un substrat semi-conducteur une couche (11) isolante pouvant être attaquée sélectivement par rapport à celui-ci,
- on structure de façon anisotrope la couche (11) isolante et le substrat semi-conducteur de manière à laisser subsister une zone (12) semi-conductrice en forme de colonne sous la couche (11) isolante qui reste,
- on surattaque de façon isotrope la zone (12) semi-conductrice de manière à laisser subsister une zone (13) semi-conductrice amincie, et
- on dépose un diélectrique (9) de façon anisotrope sur la couche (11) isolante restante et sur le substrat semi-conducteur de manière à ce que la zone (13) semi-conductrice amincie reste entourée latéralement d'une cavité (8).
